# EUROPEAN PATENT APPLICATION

(11) **EP 4 502 517 A1**
(43) Date of publication of application: **05.02.2025**
(21) Application number: 24191683.2
(22) Date of filing: 30.07.2024
(51) Int. Cl.: F28D 1/03, F28F 9/00, F28F 9/013, B60H 1/00

(54) **HEAT EXCHANGER AND AIR CONDITIONER PROVIDED WITH SAME**

(30) Priority: 31.07.2023 JP 2023124904
(71) Applicant: Panasonic Intellectual Property Management Co., Ltd., Kadoma-shi, Osaka 571-0057 (JP)
(72) Inventor: OKUMURA, Takuya, Kadoma-shi, Osaka, 571-0057 (JP); MATSUNAGA, Takuya, Kadoma-shi, Osaka, 571-0057 (JP); HASEGAWA, Hiroshi, Kadoma-shi, Osaka, 571-0057 (JP); OHNISHI, Yukinobu, Kadoma-shi, Osaka, 571-0057 (JP); YONEZAWA, Masaru, Kadoma-shi, Osaka, 571-0057 (JP)
(74) Representative: Eisenführ Speiser

(57) **Abstract**

A heat exchanger includes first and second fin layered bodies respectively formed by layering a plurality of fins with a gap between the fins; and a coupling member that couples the first and second fin layered bodies such that fin layering directions of the first and second fin layered bodies are parallel to each other and respective one fin longitudinal direction end surfaces of the first and second fin layered bodies are adjacent to each other. The coupling member couples the first and second fin layered bodies with at least a part of the coupling member interposed between the fin longitudinal direction end surface of the first fin layered body and the fin longitudinal direction end surface of the second fin layered body.

## Description

### TECHNICAL FIELD

The present disclosure relates to a heat exchanger and an air conditioner provided with the heat exchanger.

### BACKGROUND ART

Conventionally, for example, as described in Japanese Unexamined Patent Application Publication No. 2017-180856, a plate-layered heat exchanger configured by layering a plurality of fins each formed by joining first and second plates is known. Each of the plurality of fins has an internal flow path through which a refrigerant flows. Heat exchange is performed between air flowing between the plurality of fins and the refrigerant flowing inside each of the fins.

A layered body (fin layered body) of the plurality of fins in such a plate-layered heat exchanger is produced by alternately layering first and second plates and then heating the plates while pressing the plates in a layering direction. For this purpose, each of the first and second plates is produced, for example, by press-molding a metal thin plate (brazing plate) provided with a brazing material layer on both surfaces.

### SUMMARY

Meanwhile, in the case of a plate-layered heat exchanger, when the number of layered fins increases, the fin layered body has a flat plate shape that is long in a fin layering direction. Therefore, the fin layered body is easily deformed in a direction orthogonal to the fin layering direction. In particular, in a case where the fin has a lateral direction and a longitudinal direction, the fin layered body is easily deformed in the lateral direction. As a result, when an impact (external force) is applied to the fin layered body in the lateral direction and/or the longitudinal direction (for example, when the heat exchanger alone is dropped during conveyance, or a product is dropped in a state where the heat exchanger is mounted on the product), the fin layered body is deformed.

In a case where the heat exchanger is configured by adjacently disposing the plurality of fin layered bodies such that the fin layering directions are parallel to each other, when at least one of the fin layered bodies is deformed, there is a possibility that it comes into contact with the other of the fin layered bodies. As a result, at least one of the fin layered bodies may be damaged.

Therefore, an object of the present disclosure is to suppress contact between a first fin layered body and a second fin layered body in a plate-layered heat exchanger including the first and second fin layered bodies disposed adjacent to each other such that fin layering directions are parallel to each other.

In order to solve the above problem, according to one aspect of the present disclosure, provided is a heat exchanger including:
first and second fin layered bodies respectively formed by layering a plurality of fins each including an internal flow path through which a first fluid flows with a gap through which a second fluid passes; and
a coupling member that couples the first and second fin layered bodies such that fin layering directions of the first and second fin layered bodies are parallel to each other and respective one fin longitudinal direction end surfaces of the first and second fin layered bodies are adjacent to each other,
in which the coupling member couples the first and second fin layered bodies with at least a part of the coupling member interposed between the fin longitudinal direction end surface of the first fin layered body and the fin longitudinal direction end surface of the second fin layered body.

Furthermore, according to another aspect of the present disclosure, provided is an air conditioner including:
a compressor that delivers a refrigerant;
a heat exchanger through which a refrigerant flows; and
a fan that generates a flow of air passing through the heat exchanger,
in which the heat exchanger includes:
   first and second fin layered bodies respectively formed by layering a plurality of fins each including an internal flow path through which a refrigerant flows with a gap through which air passes; and
   a coupling member that couples the first and second fin layered bodies such that fin layering directions of the first and second fin layered bodies are parallel to each other and respective one fin longitudinal direction end surfaces of the first and second fin layered bodies are adjacent to each other, and
the coupling member couples the first and second fin layered bodies with at least a part of the coupling member interposed between the fin longitudinal direction end surface of the first fin layered body and the fin longitudinal direction end surface of the second fin layered body.

According to the present disclosure, in the plate-layered heat exchanger including the first and second fin layered bodies disposed adjacent to each other such that the fin layering directions are parallel to each other, it is possible to suppress contact between the first fin layered body and the second fin layered body.

### BRIEF DESCRIPTION OF DRAWINGS

Fig. 1 is a schematic diagram of an air conditioner according to a first embodiment of the present disclosure;
Fig. 2 is a schematic cross-sectional view of an indoor unit in the air conditioner;
Fig. 3 is a perspective view of a fin layered body in a heat exchanger;
Fig. 4 is an exploded perspective view of the fin layered body;
Fig. 5 is a perspective view illustrating two fin layered bodies in a coupled state;
Fig. 6 is a front perspective view of a coupling member that couples two fin layered bodies;
Fig. 7 is a rear perspective view of the coupling member;
Fig. 8 is a cross-sectional view of the coupling member in a state where the two fin layered bodies are coupled as viewed in a fin layering direction;
Fig. 9 is a front perspective view of a coupling member coupling two fin layered bodies in a heat exchanger according to a second embodiment;
Fig. 10 is a rear perspective view of the coupling member according to the second embodiment;
Fig. 11 is a cross-sectional view of the coupling member according to the second embodiment in a state where the two fin layered bodies are coupled as viewed in a fin layering direction;
Fig. 12 is a front perspective view of a coupling member coupling two fin layered bodies in a heat exchanger according to a third embodiment;
Fig. 13 is a rear perspective view of the coupling member according to the third embodiment;
Fig. 14 is a cross-sectional view of the coupling member according to the third embodiment in a state where the two fin layered bodies are coupled as viewed in a fin layering direction;
Fig. 15 is a front perspective view of a coupling member coupling two fin layered bodies in a heat exchanger according to a fourth embodiment;
Fig. 16 is a rear perspective view of the coupling member according to the fourth embodiment;
Fig. 17 is a cross-sectional view of the coupling member according to the fourth embodiment in a state where the two fin layered bodies are coupled as viewed in a fin layering direction;
Fig. 18 is a front perspective view of a coupling member coupling two fin layered bodies in a heat exchanger according to a fifth embodiment;
Fig. 19 is a rear perspective view of the coupling member according to the fifth embodiment;
Fig. 20 is a cross-sectional view of the coupling member according to the fifth embodiment in a state where the two fin layered bodies are coupled as viewed in a fin layering direction;
Fig. 21 is a front perspective view of a coupling member coupling two fin layered bodies in a heat exchanger according to a sixth embodiment;
Fig. 22 is a rear perspective view of the coupling member according to the sixth embodiment;
Fig. 23 is a cross-sectional view of the coupling member according to the sixth embodiment in a state where the two fin layered bodies are coupled as viewed in a fin layering direction;
Fig. 24 is a front perspective view of a coupling member coupling two fin layered bodies in a heat exchanger according to a seventh embodiment;
Fig. 25 is a rear perspective view of the coupling member according to the seventh embodiment;
Fig. 26 is a cross-sectional view of the coupling member according to the seventh embodiment in a state where the two fin layered bodies are coupled as viewed in a fin layering direction;
Fig. 27 is a front perspective view of a coupling member coupling two fin layered bodies in a heat exchanger according to an eighth embodiment;
Fig. 28 is a rear perspective view of the coupling member according to the eighth embodiment; and
Fig. 29 is a cross-sectional view of the coupling member according to the eighth embodiment in a state where the two fin layered bodies are coupled as viewed in a fin layering direction.

### DETAILED DESCRIPTION

A heat exchanger according to one aspect of the present disclosure includes: first and second fin layered bodies respectively formed by layering a plurality of fins each including an internal flow path through which a first fluid flows with a gap through which a second fluid passes; and a coupling member that couples the first and second fin layered bodies such that fin layering directions of the first and second fin layered bodies are parallel to each other and respective one fin longitudinal direction end surfaces of the first and second fin layered bodies are adjacent to each other, in which the coupling member couples the first and second fin layered bodies with at least a part of the coupling member interposed between the fin longitudinal direction end surface of the first fin layered body and the fin longitudinal direction end surface of the second fin layered body.

According to such an aspect, in the plate-layered heat exchanger including the first and second fin layered bodies disposed adjacent to each other such that the fin layering directions are parallel to each other, contact between the first fin layered body and the second fin layered body can be suppressed.

For example, the first and second fin layered bodies may be coupled by the coupling member such that the fin longitudinal direction end surface in the first fin layered body and the fin longitudinal direction end surface in the second fin layered body approach each other from one end toward another end in a fin lateral direction while facing each other.

For example, the coupling member may include: a first fin layered body support portion that contacts and supports the first fin layered body; and a second fin layered body support portion that contacts and supports the second fin layered body.

For example, the first fin layered body support portion may include a fin longitudinal direction contact portion in contact with the fin longitudinal direction end surface of the first fin layered body.

For example, the fin longitudinal direction contact portion of the first fin layered body support portion may include a plurality of through holes.

For example, the first fin layered body support portion may include a fin lateral direction contact portion in contact with one fin lateral direction end surface of the first fin layered body.

For example, the second fin layered body support portion may include a fin longitudinal direction contact portion in contact with the fin longitudinal direction end surface of the second fin layered body.

For example, the second fin layered body support portion may include a fin lateral direction contact portion in contact with one fin lateral direction end surface of the second fin layered body.

For example, the first fin layered body support portion may include: a fin longitudinal direction contact portion in contact with the fin longitudinal direction end surface of the first fin layered body; and a fin lateral direction contact portion in contact with one fin lateral direction end surface of the first fin layered body, the second fin layered body support portion may include a fin lateral direction contact portion in contact with one fin lateral direction end surface of the second fin layered body, the fin longitudinal direction contact portion of the first fin layered body support portion may include a plurality of through holes, and the coupling member may further include a connection portion that extends and connects between the fin lateral direction contact portion in the first fin layered body support portion and the fin lateral direction contact portion in the second fin layered body support portion.

For example, the first fin layered body support portion may include: a fin longitudinal direction contact portion in contact with the fin longitudinal direction end surface of the first fin layered body; a first fin lateral direction contact portion in contact with one fin lateral direction end surface of the first fin layered body; and a second fin lateral direction contact portion in contact with another fin lateral direction end surface of the first fin layered body, the second fin layered body support portion may include a fin lateral direction contact portion in contact with one fin lateral direction end surface of the second fin layered body, the fin longitudinal direction contact portion of the first fin layered body support portion may include a plurality of through holes, the coupling member may include a connection portion that extends and connects between the first fin lateral direction contact portion in the first fin layered body support portion and the fin lateral direction contact portion in the second fin layered body support portion, the second fin layered body may include a chamfer surface between the fin longitudinal direction end surface and the another fin lateral direction end surface, and the fin longitudinal direction contact portion in the first fin layered body support portion may contact the chamfer surface of the second fin layered body.

For example, the first fin layered body may include a first chamfer surface between the fin longitudinal direction end surface and one fin lateral direction end surface, and a second chamfer surface between the fin longitudinal direction end surface and another fin lateral direction end surface, the second fin layered body may include a third chamfer surface between the fin longitudinal direction end surface and one fin lateral direction end surface, and a fourth chamfer surface between the fin longitudinal direction end surface and another fin lateral direction end surface, the first fin layered body support portion may include: a fin longitudinal direction contact portion in contact with the fin longitudinal direction end surface of the first fin layered body; a first fin lateral direction contact portion in contact with one fin lateral direction end surface of the first fin layered body; a second fin lateral direction contact portion in contact with another fin lateral direction end surface of the first fin layered body; a first chamfer surface contact portion in contact with the first chamfer surface; and a second chamfer surface contact portion in contact with the second chamfer surface, the second fin layered body support portion includes: a fin lateral direction contact portion in contact with the one fin lateral direction end surface of the second fin layered body; and a third chamfer surface contact portion in contact with the third chamfer surface, the coupling member may include a connection portion that extends and connects between the first fin lateral direction contact portion in the first fin layered body support portion and the third chamfer surface contact portion in the second fin layered body support portion, and the fin longitudinal direction contact portion in the first fin layered body support portion may contact the fourth chamfer surface of the second fin layered body.

For example, each of the first and second fin layered bodies may include end plates at both ends in each of the fin layering directions, and both ends of the coupling member in the fin layering direction may be fixed to the end plates of each of the first and second fin layered bodies.

For example, the coupling member may be a pressed product of one metal plate.

An air conditioner according to another aspect of the present disclosure includes: a compressor that delivers a refrigerant; a heat exchanger through which a refrigerant flows; and a fan that generates a flow of air passing through the heat exchanger, in which the heat exchanger includes: first and second fin layered bodies respectively formed by layering a plurality of fins each including an internal flow path through which a refrigerant flows with a gap through which air passes; and a coupling member that couples the first and second fin layered bodies such that fin layering directions of the first and second fin layered bodies are parallel to each other and respective one fin longitudinal direction end surfaces of the first and second fin layered bodies are adjacent to each other, and the coupling member couples the first and second fin layered bodies with at least a part of the coupling member interposed between the fin longitudinal direction end surface of the first fin layered body and the fin longitudinal direction end surface of the second fin layered body.

According to such another aspect, in the plate-layered heat exchanger including the first and second fin layered bodies disposed adjacent to each other such that the fin layering directions are parallel to each other, contact between the first fin layered body and the second fin layered body can be suppressed.

Hereinafter, embodiments of the present disclosure will be described with reference to the drawings.

### (First Embodiment)

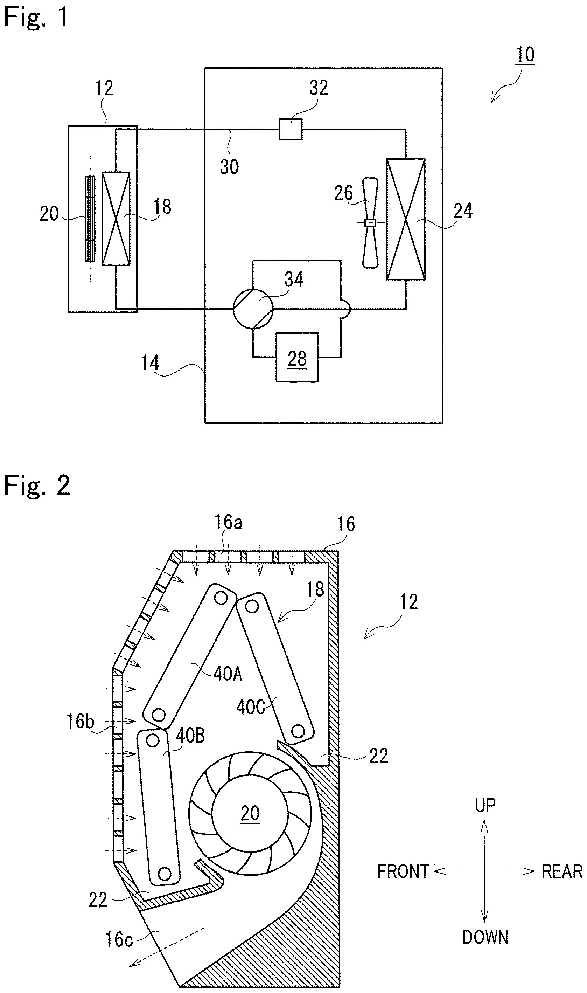

Fig. 1 is a schematic diagram of an air conditioner according to an embodiment of the present disclosure. Furthermore, Fig. 2 is a schematic cross-sectional view of an indoor unit in the air conditioner.

As illustrated in Fig. 1, an air conditioner 10 according to the present first embodiment includes an indoor unit 12 disposed in a room and an outdoor unit 14 disposed outside the room.

As illustrated in Figs. 1 and 2, the indoor unit 12 includes a casing 16 installed in a room, a heat exchanger 18 that is disposed in the casing 16 and exchanges heat with indoor air, and a cross flow fan 20 that generates a flow of indoor air so that the indoor air passes through the heat exchanger 18. The casing 16 is formed with an intake port 16a that opens upward, an intake port 16b that opens forward, and a blowout port 16c that faces obliquely downward. When the cross flow fan 20 rotates, indoor air flows into the casing 16 through the intake ports 16a, 16b and passes through the heat exchanger 18. The air having passed through the heat exchanger 18 is blown out of the casing 16 through the blowout port 16c. Note that a drain pan 22 for storing moisture in the air condensed on a surface of the heat exchanger 18 is provided below the heat exchanger 18.

As illustrated in Fig. 1, the outdoor unit 14 is mounted with a heat exchanger 24 that exchanges heat with outdoor air, an axial fan 26 that generates a flow of outdoor air so that the outdoor air passes through the heat exchanger 24, and a compressor 28 that delivers a refrigerant (first fluid) passing through the heat exchangers 18, 24. The heat exchanger 18, the heat exchanger 24, and the compressor 28 are connected via a refrigerant pipe 30. An expansion valve 32 that decompresses the refrigerant and a four-way valve 34 that changes a flow direction of the refrigerant are disposed on the refrigerant pipe 30.

During a cooling operation, the refrigerant is delivered from the compressor 28, sequentially passes through the four-way valve 34, the heat exchanger 24 of the outdoor unit 14, the expansion valve 32, and the heat exchanger 18 of the indoor unit 12, and returns to the compressor 28. During a heating operation, the refrigerant is delivered from the compressor 28, sequentially passes through the four-way valve 34, the heat exchanger 18 of the indoor unit 12, the expansion valve 32, and the heat exchanger 24 of the outdoor unit 14, and returns to the compressor 28. The flow of the refrigerant during the cooling operation and the flow of the refrigerant during the heating operation are switched by the four-way valve 34. Note that, during the cooling operation, water droplets generated by dew condensation of indoor air on the surface of the heat exchanger 18 flow along the surface of the heat exchanger 18 and drop into the drain pan 22.

As illustrated in Fig. 2, the heat exchanger 18 of the indoor unit 12 includes a plurality of fin layered bodies 40A to 40C.

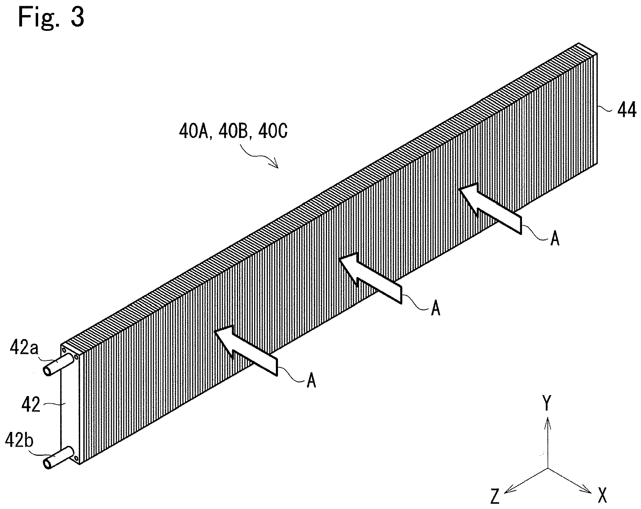

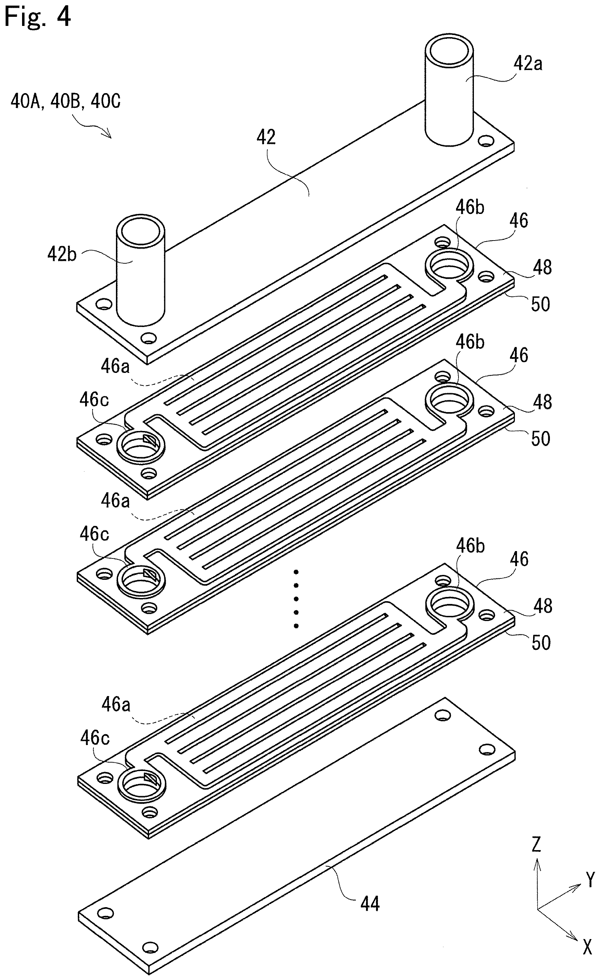

Fig. 3 is a perspective view of a fin layered body in the heat exchanger. Furthermore, Fig. 4 is an exploded perspective view of the fin layered body. Note that an X-Y-Z orthogonal coordinate system illustrated in the drawings is for facilitating understanding of the embodiment, and does not limit the embodiment. An X-axis direction indicates a lateral direction of the fins constituting the fin layered bodies 40A to 40C in the heat exchanger 18, a Y-axis direction indicates a longitudinal direction of the fins, and a Z-axis direction indicates a thickness direction and a fin layering direction of the fins. Furthermore, in the drawings, white an arrow indicates a flow direction of air A (a second fluid) flowing into the fin layered bodies 40A to 40C. In the case of the present first embodiment, the air Apassing through the fin layered bodies 40Ato 40C flows mainly in a fin lateral direction (X-axis direction).

As illustrated in Figs. 3 and 4, each of the fin layered bodies 40A to 40C includes first and second end plates 42, 44 at both ends in the fin layering direction. The first end plate 42 is provided with an inflow-side connection pipe 42a that is connected to a refrigerant pipe 30 and through which the refrigerant flows, and an outflow-side connection pipe 42b that is connected to the refrigerant pipe 30 and through which the refrigerant flows.

As illustrated in Fig. 4, each of the fin layered bodies 40Ato 40C is formed by layering a plurality of fins 46 having a substantially rectangular shape in a fin thickness direction (Z-axis direction). By layering a large number of the fins 46, each of the fin layered bodies 40A to 40C has a flat plate shape elongated in the fin layering direction as illustrated in Fig. 3. Note that, in the case of the present first embodiment, the plurality of fins 46 are layered in the left-right direction of indoor unit 12.

As illustrated in Fig. 4, an internal flow path 46a through which the refrigerant flows is provided inside each of the plurality of fins 46. In the case of the present first embodiment, each of the plurality of fins 46 is formed by joining a first plate 48 and a second plate 50 to each other in the fin layering direction (Z-axis direction) of the fin layered body 40. The internal flow path 46a is formed between the first plate 48 and the second plate 50.

For example, the first plate 48 and the second plate 50 are produced by processing, for example, pressing a metal thin plate, a so-called brazing plate, in which brazing material layers are provided on both surfaces. The brazing plate is produced, for example, by forming an aluminum-silicon alloy layer as a brazing material on both surfaces of a thin plate produced from an aluminum alloy. The first plate 48 and the second plate 50 are joined by the brazing material layer being melted once by heating and solidified again.

By joining the first plate 48 and the second plate 50 to each other, the internal flow path 46a through which the refrigerant flows is formed therebetween. In the case of the present first embodiment, a recess is formed on an inner surface of the first plate 48 facing the second plate 50. The second plate 50 covers the recess to form the internal flow path 46a.

Furthermore, the internal flow paths 46a communicate with the insides of tubular headers 46b, 46c provided at both ends of the fin 46 in the fin longitudinal direction (Y-axis direction). That is, the internal flow path 46a is provided at the center portion of the fin 46 in the fin longitudinal direction, and both ends thereof communicate with the insides of the headers 46b, 46c. Furthermore, each of these headers 46b, 46c is formed by joining a cylindrical portion formed in the first plate 48 and a cylindrical portion formed in the second plate 50.

The headers 46b of the plurality of fins 46 are coupled and joined to constitute an inflow-side manifold. The inflow-side manifold is connected to the inflow-side connection pipe 42a of the first end plate 42. As a result, the refrigerant that has passed through the inflow-side connection pipe 42a flows into the internal flow paths 46a of the respective fins 46.

Furthermore, the headers 46c of the plurality of fins 46 are coupled and joined to constitute an outflow-side manifold. The outflow-side manifold is connected to the outflow-side connection pipe 42b of the first end plate 42. As a result, the refrigerant flowing out of the internal flow paths 46a of the fins 46 flows toward the outflow-side connection pipe 42b.

Each of the plurality of fins 46 is layered with a gap between them. Specifically, the gap between two adjacent fins 46 is formed by joining the header 46b of one fin 46 to the header 46b of the other fin 46 and joining the header 46c of one fin 46 to the header 46c of the other fin 46. The air A flows through this gap.

According to the fin layered bodies 40Ato 40C of the heat exchanger 18, heat exchange is performed between the refrigerant flowing through the internal flow paths 46a of the fins 46 and the air A flowing through the gap between the fins 46.

Furthermore, in the case of the present first embodiment, as illustrated in Fig. 2, in the heat exchanger 18, the plurality of fin layered bodies 40A to 40C are disposed in a parallel state such that the fin layering directions are parallel to each other. Furthermore, the fin layered bodies 40A and 40B are disposed adjacent to each other, and the fin layered bodies 40A and 40C are disposed adjacent to each other. Specifically, the two fin layered bodies are disposed adjacent to each other such that the end surfaces in the fin longitudinal direction are adjacent to each other. The fin layered body 40A is adjacently disposed above the fin layered body 40B, and the fin layered body 40C is adjacently disposed behind the fin layered body 40A. With such an arrangement, as illustrated in Fig. 2, the cross flow fan 20 is surrounded by the plurality of fin layered bodies 40Ato 40C as viewed in an extending direction of a rotation center line of the cross flow fan 20 (as viewed in a direction orthogonal to the drawing).

In the case of the present first embodiment, in the heat exchanger 18, the fin layered bodies 40A and 40B are coupled.

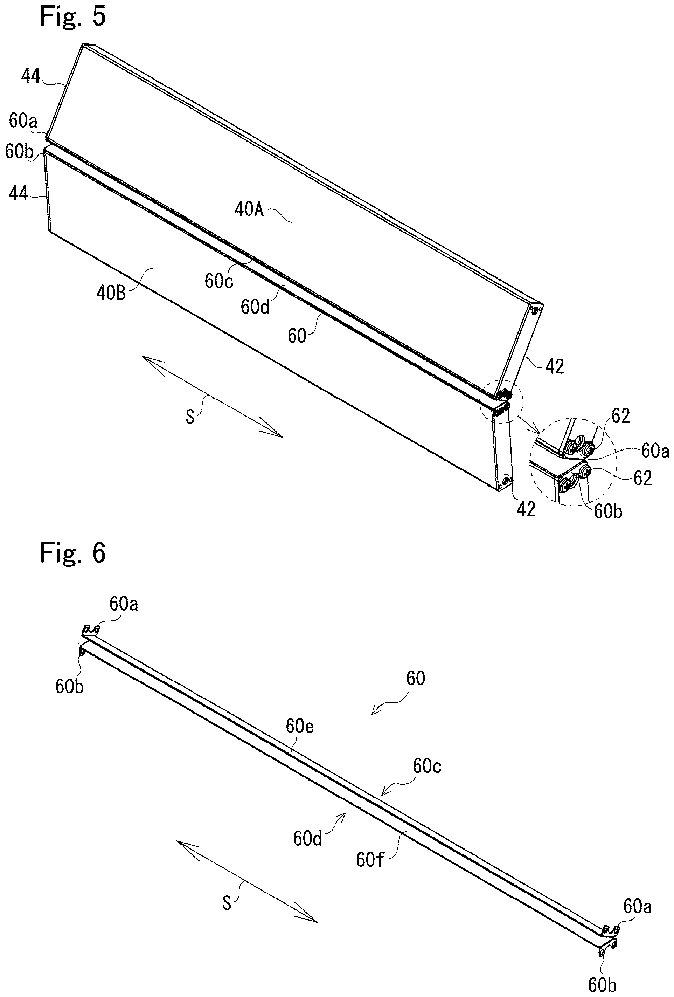

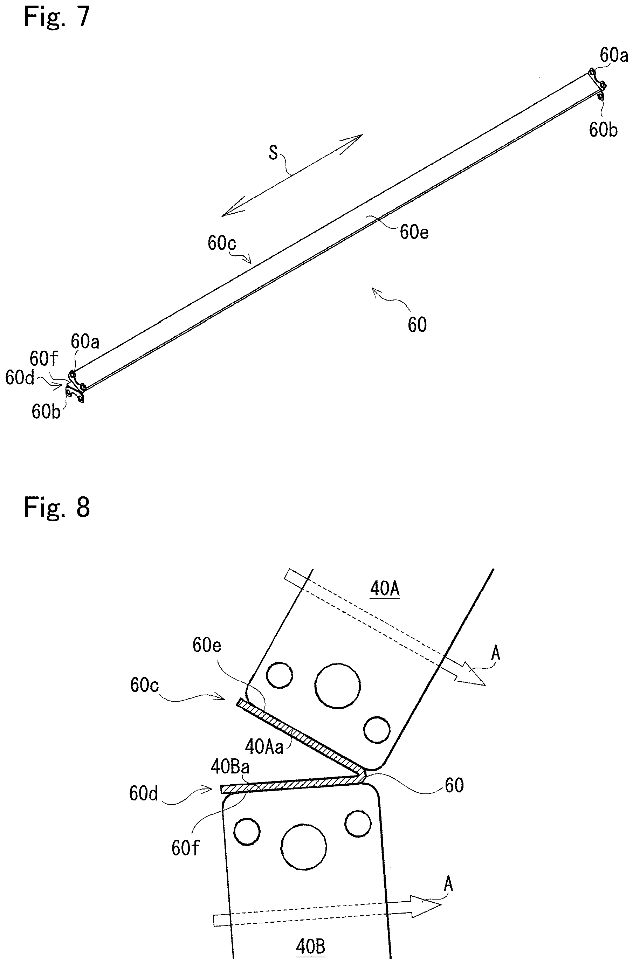

Fig. 5 is a perspective view illustrating two fin layered bodies in a coupled state. Furthermore, Fig. 6 is a front perspective view of a coupling member coupling the two fin layered bodies. Moreover, Fig. 7 is a rear perspective view of the coupling member. Fig. 8 is a cross-sectional view of the coupling member in a state where the two fin layered bodies are coupled as viewed in the fin layering direction.

As illustrated in Figs. 5 to 8, the heat exchanger 18 includes a coupling member 60 that couples the two fin layered bodies 40A, 40B. The coupling member 60 is produced by, for example, pressing (that is, cutting and bending) a single metal plate such as stainless steel. Furthermore, the coupling member 60 is a member elongated in the fin layering direction of the fin layered bodies 40A, 40B. Note that, in the drawings, the fin layering direction of the fin layered bodies 40A, 40B is indicated by an arrow S.

In the case of the present first embodiment, the coupling member 60 is coupled to each of the fin layered bodies 40A, 40B at both ends in the fin layering direction. Specifically, the coupling member 60 includes a first fixing portion 60a fixed to the end plates 42, 44 provided at both ends of one fin layered body 40A, and a second fixing portion 60b fixed to the end plates 42, 44 provided at both ends of the other fin layered body 40B. The first and second fixing portions 60a, 60b are fixed to the end plates 42, 44 of the first and second fin layered bodies 40A, 40B, respectively, for example, via fixing screws 62.

Furthermore, in the case of the present first embodiment, the coupling member 60 includes a first fin layered body support portion 60c that supports one fin layered body 40A and a second fin layered body support portion 60d that supports the other fin layered body 40B.

In the case of the present first embodiment, as illustrated in Fig. 8, the fin layered bodies 40A, 40B are disposed such that end surfaces (fin longitudinal direction end surfaces) 40Aa, 40Ba in one fin longitudinal direction are adjacent to each other. Moreover, the fin layered bodies 40A, 40B are disposed adjacent to each other such that the fin longitudinal direction end surfaces 40Aa, 40Ba face each other and approach each other from one end toward the other end in the fin lateral direction. That is, the fin longitudinal direction end surfaces 40Aa, 40Ba approach each other from the upstream side toward the downstream side in the flow direction of the air A passing through the fin layered bodies 40A, 40B.

In the case of the present first embodiment, as illustrated in Fig. 8, a portion of the coupling member 60 disposed between the fin longitudinal direction end surfaces 40Aa, 40Ba of the fin layered bodies 40A, 40B has a V-shaped cross section as viewed in the fin layering direction. As illustrated in Figs. 6 and 7, the first fin layered body support portion 60c includes the first fixing portions 60a at both ends in the fin layering direction. Furthermore, the second fin layered body support portion 60d also includes the second fixing portions 60b at both ends in the fin layering direction. As illustrated in Fig. 8, the first and second fin layered body support portions 60c, 60d are connected to each other at ends in the fin lateral direction (that is, ends on the downstream side in the flow direction of the air A).

The first fin layered body support portion 60c of the coupling member 60 includes a fin longitudinal direction contact portion 60e that is in contact with the fin longitudinal direction end surface 40Aa of one fin layered body 40A and supports the fin layered body 40A in the fin longitudinal direction. In the case of the present first embodiment, the entire first fin layered body support portion 60c is the fin longitudinal direction contact portion 60e itself. The fin longitudinal direction contact portion 60e in the first fin layered body support portion 60c has a thin plate shape extending in the fin layering direction. Furthermore, the fin longitudinal direction contact portion 60e is in contact with the fin longitudinal direction end surface 40Aa of the fin layered body 40A over the entire fin layering direction. That is, the fin longitudinal direction contact portion 60e is in contact with the plurality of fins 46 in the fin longitudinal direction in the fin layered body 40A. The coupling member 60 supports one fin layered body 40A via such the first fin layered body support portion 60c.

The second fin layered body support portion 60d of the coupling member 60 includes a fin longitudinal direction contact portion 60f that is in contact with the fin longitudinal direction end surface 40Ba of the other fin layered body 40B and supports the second fin layered body 40B in the fin longitudinal direction. In the case of the present first embodiment, the entire second fin layered body support portion 60d is the fin longitudinal direction contact portion 60f itself. The fin longitudinal direction contact portion 60f in the second fin layered body support portion 60d has a thin plate shape extending in the fin layering direction. Furthermore, the fin longitudinal direction contact portion 60f is in contact with the fin longitudinal direction end surface 40Ba of the fin layered body 40B over the entire fin layering direction. That is, the fin longitudinal direction contact portion 60f is in contact with the plurality of fins 46 in the fin longitudinal direction in the fin layered body 40B. The coupling member 60 supports the other fin layered body 40B via such the second fin layered body support portion 60d.

According to such the coupling member 60, the fin layered bodies 40A, 40B are fixed to each other. Furthermore, a part of the coupling member 60 is interposed between the fin longitudinal direction end surface 40Aa of the fin layered body 40A and the fin longitudinal direction end surface 40Ba of the fin layered body 40B adjacent to each other. As a result, contact between the fin layered bodies 40A, 40B when at least one of the fin layered bodies 40A, 40B is deformed is suppressed.

Moreover, in the case of the present first embodiment, the fin longitudinal direction contact portion 60e of the first fin layered body support portion 60c of the coupling member 60 is in contact with and supports the fin longitudinal direction end surface 40Aa on a side closer to the other fin layered body 40B in the one fin layered body 40A. As a result, displacement of the fin layered body 40A is suppressed in the fin longitudinal direction of the fin layered body 40A, particularly in a direction approaching the other fin layered body 40B.

At the same time, the fin longitudinal direction contact portion 60f of the second fin layered body support portion 60d is in contact with and supports the fin longitudinal direction end surface 40Ba on a side closer to the one fin layered body 40A in the other fin layered body 40B. As a result, displacement of the fin layered body 40B is suppressed in the fin longitudinal direction of the fin layered body 40B, particularly in a direction approaching one fin layered body 40A.

According to the present first embodiment as described above, in the plate-layered heat exchanger 18 including the fin layered bodies 40A, 40B disposed adjacent to each other such that the fin layering directions are parallel to each other, contact between the fin layered body 40A and the fin layered body 40B can be suppressed.

### (Second Embodiment)

The present second embodiment is different from the first embodiment described above with respect to a coupling member. Therefore, the present second embodiment will be described focusing on the different coupling member.

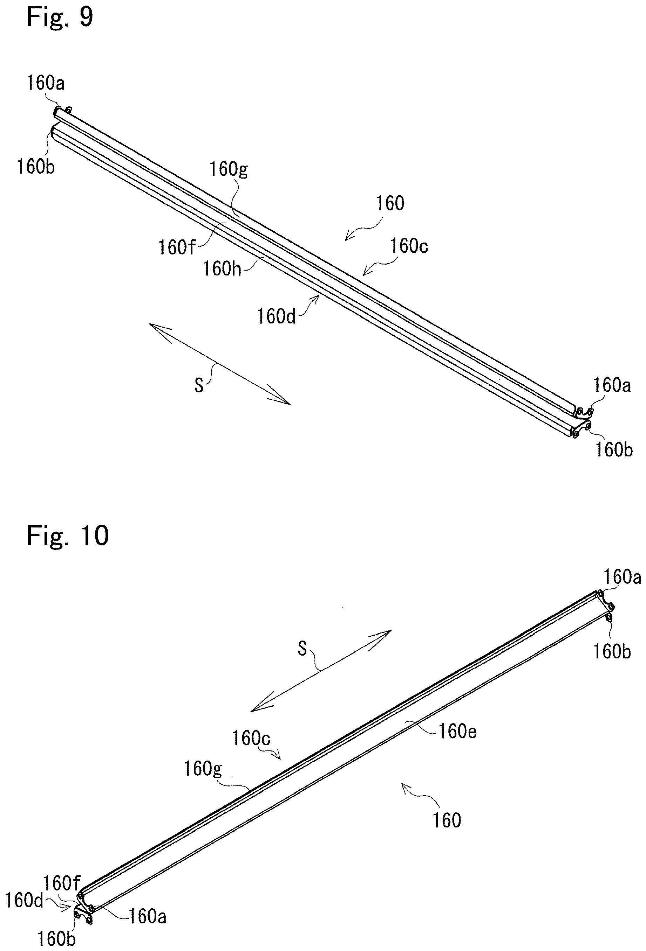

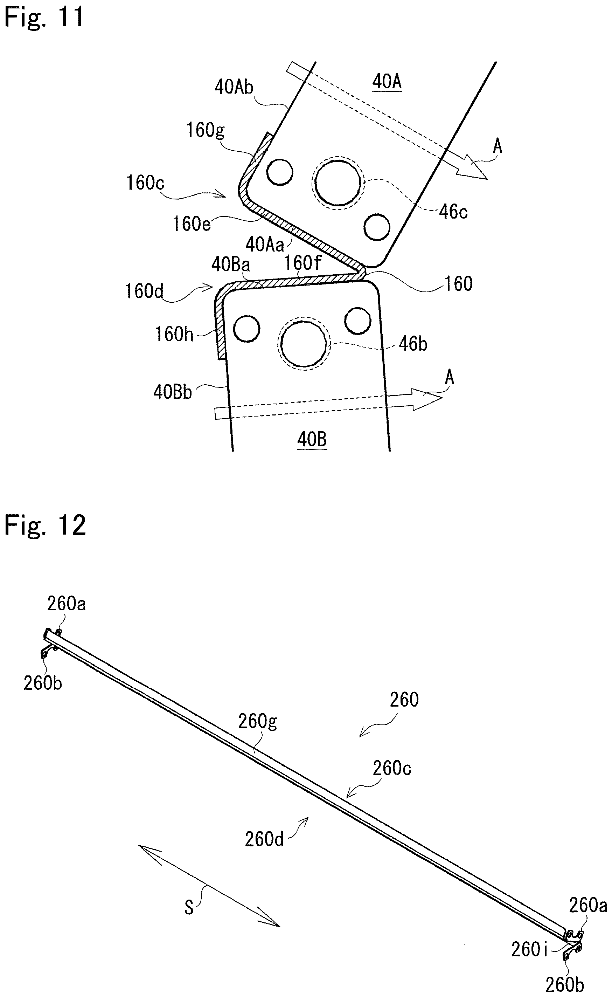

Fig. 9 is a front perspective view of a coupling member that couples two fin layered bodies in a heat exchanger according to the second embodiment. Furthermore, Fig. 10 is a rear perspective view of the coupling member according to the second embodiment. Fig. 11 is a cross-sectional view of the coupling member according to the second embodiment in a state where the two fin layered bodies are coupled as viewed in the fin layering direction.

As illustrated in Figs. 9 to 11, a coupling member 160 in the heat exchanger according to the present second embodiment is produced by, for example, pressing a single metal plate such as stainless steel. Furthermore, the coupling member 160 includes a first fixing portion 160a fixed to end plates provided at both ends of one fin layered body 40A and a second fixing portion 160b fixed to end plates provided at both ends of the other fin layered body 40B.

In the case of the present second embodiment, the coupling member 160 includes a first fin layered body support portion 160c that supports the one fin layered body 40A and a second fin layered body support portion 160d that supports the other fin layered body 40B.

Furthermore, in the case of the present second embodiment, the first fin layered body support portion 160c of the coupling member 160 includes a fin longitudinal direction contact portion 160e that is in contact with a fin longitudinal direction end surface 40Aa of the one fin layered body 40A and supports the fin layered body 40A in the fin longitudinal direction. Furthermore, the second fin layered body support portion 160d includes a fin longitudinal direction contact portion 160f that is in contact with a fin longitudinal direction end surface 40Ba of the other fin layered body 40B and supports the fin layered body 40B in the fin longitudinal direction. The fin longitudinal direction contact portions 160e, 160f have a thin plate shape extending in the fin layering direction. Furthermore, the fin longitudinal direction contact portions 160e, 160f are connected to each other at one end in the fin lateral direction (that is, an end on the downstream side in the flow direction of air A).

Moreover, in the case of the present second embodiment, the first fin layered body support portion 160c of the coupling member 160 includes a fin lateral direction contact portion 160g that is in contact with one fin lateral direction end surface 40Ab of the fin layered body 40A in the fin lateral direction to support the fin layered body 40A. In the case of the present second embodiment, the fin lateral direction contact portion 160g has a thin plate shape extending in the fin layering direction, and is in contact with the fin lateral direction end surface 40Ab of the fin layered body 40A on a side where the air A flows in.

In the case of the present second embodiment, the fin lateral direction contact portion 160g in the first fin layered body support portion 160c of the coupling member 160 extends from an upstream end in the flow direction of the air A in the fin longitudinal direction contact portion 160e. Note that an extension length of the fin lateral direction contact portion 160g from the fin longitudinal direction contact portion 160e is preferably a length that does not exceed a header 46c of a fin 46 in the fin layered body 40A. Thus, the flow of the air A passing through the longitudinal center portion (that is, the portion provided with the internal flow path 46a through which the refrigerant flows) of the fin 46 in the fin layered body 40A is prevented from being obstructed by the fin lateral direction contact portion 160g.

Similarly, the second fin layered body support portion 160d of the coupling member 160 includes a fin lateral direction contact portion 160h that is in contact with one fin lateral direction end surface 40Bb of the fin layered body 40B in the fin lateral direction to support the fin layered body 40B. In the case of the present second embodiment, the fin lateral direction contact portion 160h has a thin plate shape extending in the fin layering direction, and is in contact with the fin lateral direction end surface 40Bb of the fin layered body 40B on a side where the air A flows in.

Furthermore, in the case of the present second embodiment, the fin lateral direction contact portion 160h in the second fin layered body support portion 160d of the coupling member 160 extends from an upstream end in the flow direction of the air A in the fin longitudinal direction contact portion 160f. Note that an extension length of the fin lateral direction contact portion 160h from the fin longitudinal direction contact portion 160f is preferably a length that does not exceed a header 46b of the fin 46 in the fin layered body 40B. Thus, the flow of the air A along the longitudinal center portion (that is, the portion provided with the internal flow path 46a through which the refrigerant flows) of the fin 46 in the fin layered body 40B is prevented from being obstructed by the fin lateral direction contact portion 160h.

According to the present second embodiment, similarly to the first embodiment described above, in the plate-layered heat exchanger including the fin layered bodies 40A, 40B disposed adjacent to each other such that the fin layering directions are parallel to each other, contact between the fin layered body 40A and the fin layered body 40B can be suppressed.

Furthermore, according to the present second embodiment, the coupling member 160 suppresses displacement of each of the fin layered bodies 40A, 40B in the fin lateral direction, particularly toward the upstream side in the flow direction of the air A. Thus, each of the fin layered bodies 40A, 40B is prevented from coming into contact with another component of the adjacent air conditioner on the upstream side thereof.

### (Third Embodiment)

The present third embodiment is different from the first embodiment described above with respect to a coupling member. Therefore, the present third embodiment will be described focusing on the different coupling member.

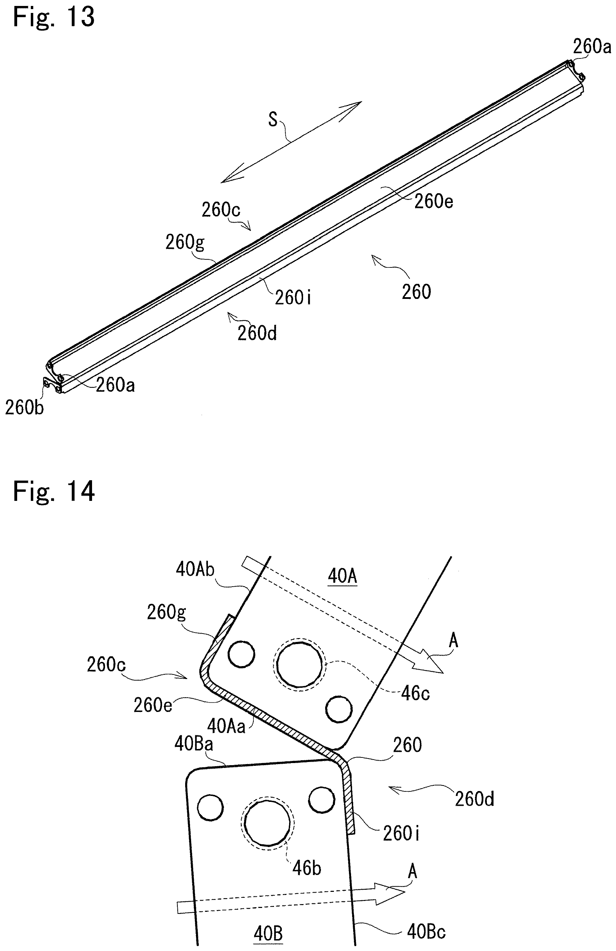

Fig. 12 is a front perspective view of a coupling member coupling two fin layered bodies in a heat exchanger according to the third embodiment. Furthermore, Fig. 13 is a rear perspective view of the coupling member according to the third embodiment. Fig. 14 is a cross-sectional view of the coupling member according to the third embodiment in a state where the two fin layered bodies are coupled as viewed in the fin layering direction.

As illustrated in Figs. 12 to 14, a coupling member 260 in the heat exchanger according to the present third embodiment is produced by, for example, pressing a single metal plate such as stainless steel. Furthermore, the coupling member 260 includes a first fixing portion 260a fixed to end plates provided at both ends of one fin layered body 40A and a second fixing portion 260b fixed to end plates provided at both ends of the other fin layered body 40B.

In the case of the present third embodiment, the coupling member 260 includes a first fin layered body support portion 260c that supports the one fin layered body 40A and a second fin layered body support portion 260d that supports the other fin layered body 40B.

Furthermore, in the case of the present third embodiment, the first fin layered body support portion 260c of the coupling member 260 includes a fin longitudinal direction contact portion 260e that is in contact with a fin longitudinal direction end surface 40Aa of the one fin layered body 40A and supports the fin layered body 40A in the fin longitudinal direction. The fin longitudinal direction contact portion 260e has a thin plate shape extending in the fin layering direction. Note that the second fin layered body support portion 260d does not substantially include a portion in contact with a fin longitudinal direction end surface 40Ba of the other fin layered body 40B.

Moreover, in the case of the present third embodiment, the first fin layered body support portion 260c of the coupling member 260 includes a fin lateral direction contact portion 260g that is in contact with one fin lateral direction end surface 40Ab of the fin layered body 40A in the fin lateral direction to support the fin layered body 40A. In the case of the present third embodiment, the fin lateral direction contact portion 260g has a thin plate shape extending in the fin layering direction, and is in contact with the fin lateral direction end surface 40Ab of the fin layered body 40A on a side where air A flows in. Furthermore, the fin lateral direction contact portion 260g is connected to one end (that is, an upstream end in the flow direction of the air A) of the fin longitudinal direction contact portion 260e in the fin lateral direction.

The second fin layered body support portion 260d of the coupling member 260 includes a fin lateral direction contact portion 260i that is in contact with the other fin lateral direction end surface 40Bc of the fin layered body 40B in the fin lateral direction to support the fin layered body 40B. In the case of the present third embodiment, the fin lateral direction contact portion 260i has a thin plate shape extending in the fin layering direction, and is in contact with the fin lateral direction end surface 40Bc of the fin layered body 40B on a side where the air A flows out. Furthermore, the fin lateral direction contact portion 260i is connected to the other end (that is, a downstream end in the flow direction of the air A) in the fin lateral direction of the fin longitudinal direction contact portion 260e in the first fin layered body support portion 260c.

According to the present third embodiment, similarly to the first embodiment described above, in the plate-layered heat exchanger including the fin layered bodies 40A, 40B disposed adjacent to each other such that the fin layering directions are parallel to each other, contact between the fin layered body 40A and the fin layered body 40B can be suppressed.

Furthermore, the coupling member 260 suppresses displacement of each of the fin layered bodies 40A, 40B in the fin lateral direction. Thus, each of the fin layered bodies 40A, 40B is prevented from coming into contact with another component of the air conditioner adjacent in the fin lateral direction.

### (Fourth Embodiment)

The present fourth embodiment is different from the first embodiment described above with respect to with a coupling member. Furthermore, the present fourth embodiment is similar to the third embodiment described above. Therefore, the present fourth embodiment will be described focusing on the different coupling member.

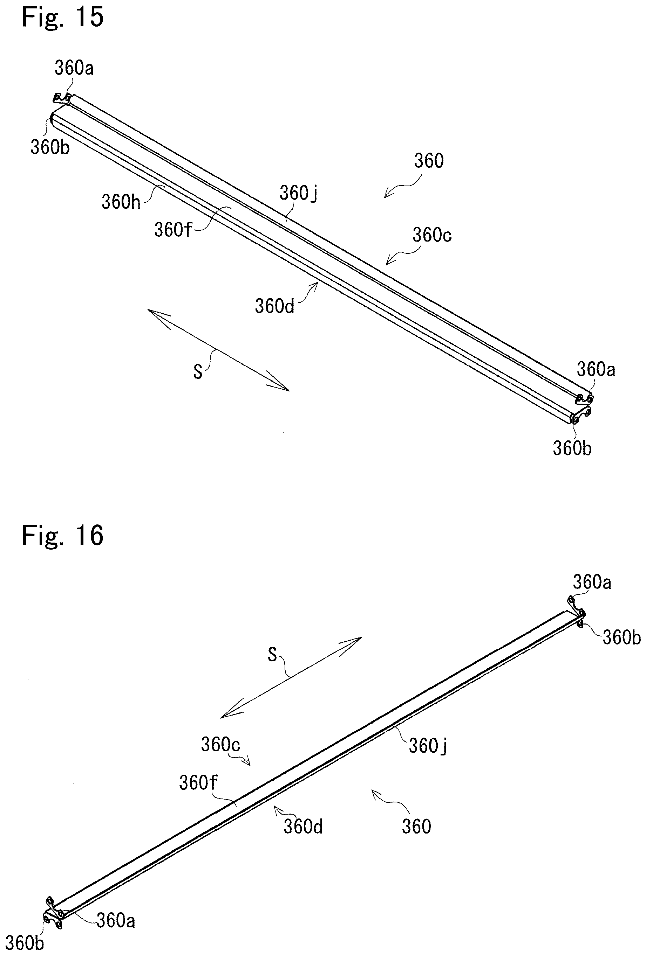

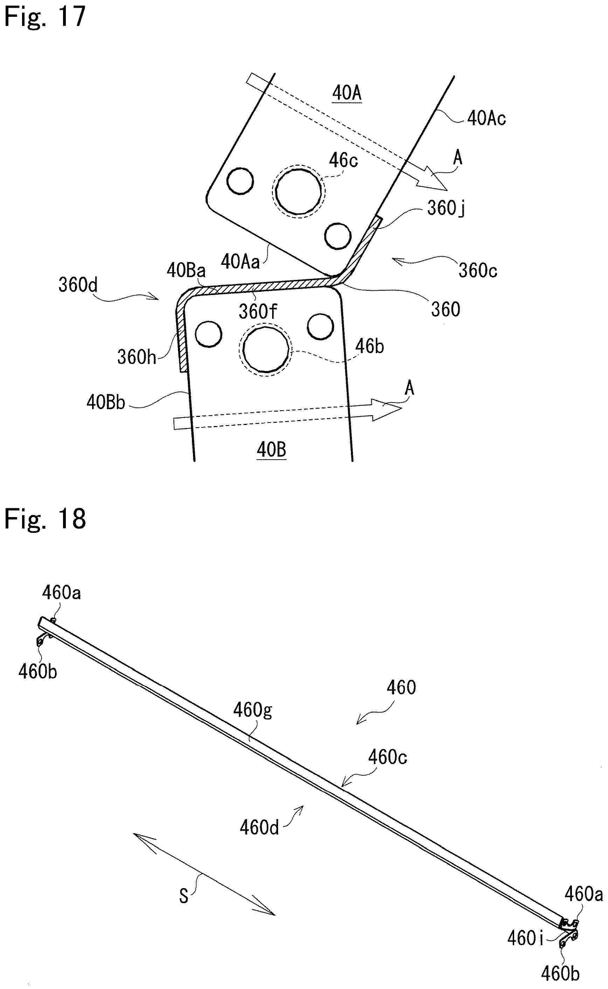

Fig. 15 is a front perspective view of a coupling member coupling two fin layered body bodies in a heat exchanger according to the fourth embodiment. Furthermore, Fig. 16 is a rear perspective view of the coupling member according to the fourth embodiment. Fig. 17 is a cross-sectional view of the coupling member according to the fourth embodiment in a state where the two fin layered bodies are coupled as viewed in the fin layering direction.

As illustrated in Figs. 15 to 17, a coupling member 360 in the heat exchanger according to the present fourth embodiment is produced by, for example, pressing a single metal plate such as stainless steel. Furthermore, the coupling member 360 includes a first fixing portion 360a fixed to end plates provided at both ends of one fin layered body 40A and a second fixing portion 360b fixed to end plates provided at both ends of the other fin layered body 40B.

In the case of the present fourth embodiment, the coupling member 360 includes a first fin layered body support portion 360c that supports the one fin layered body 40A and a second fin layered body support portion 360d that supports the other fin layered body 40B.

Furthermore, in the case of the present fourth embodiment, the second fin layered body support portion 360d of the coupling member 360 includes a fin longitudinal direction contact portion 360f that is in contact with a fin longitudinal direction end surface 40Ba of the other fin layered body 40B to support the fin layered body 40B in the fin longitudinal direction. The fin longitudinal direction contact portion 360f has a thin plate shape extending in the fin layering direction. Note that the first fin layered body support portion 360c does not substantially include a portion in contact with a fin longitudinal direction end surface 40Aa of the one fin layered body 40A.

Moreover, in the case of the present fourth embodiment, the first fin layered body support portion 360c of the coupling member 360 includes a fin lateral direction contact portion 360j that is in contact with the other fin lateral direction end surface 40Ac of the fin layered body 40A in the fin lateral direction to support the fin layered body 40A. In the case of the present fourth embodiment, the fin lateral direction contact portion 360j has a thin plate shape extending in the fin layering direction, and is in contact with the fin lateral direction end surface 40Ac of the fin layered body 40A on a side where air A flows out. Furthermore, the fin lateral direction contact portion 360j is connected to the other end (that is, a downstream end in the flow direction of the air A) in the fin lateral direction of the fin longitudinal direction contact portion 360f in the second fin layered body support portion 360d.

The second fin layered body support portion 360d of the coupling member 360 includes a fin lateral direction contact portion 360h that is in contact with one fin lateral direction end surface 40Bb of the fin layered body 40B in the fin lateral direction to support the fin layered body 40B. In the case of the present fourth embodiment, the fin lateral direction contact portion 360h has a thin plate shape extending in the fin layering direction, and is in contact with the fin lateral direction end surface 40Bb of the fin layered body 40B on a side where the air A flows in. Furthermore, the fin lateral direction contact portion 360h is connected to one end (that is, an upstream end in the flow direction of the air A) in the fin lateral direction of the fin longitudinal direction contact portion 360f in the second fin layered body support portion 360d.

According to the present fourth embodiment, similarly to the above-described first embodiment, in the plate-layered heat exchanger including the fin layered bodies 40A, 40B disposed adjacent to each other such that the fin layering directions are parallel to each other, it is possible to suppress contact between the fin layered body 40A and the fin layered body 40B.

Furthermore, the coupling member 360 suppresses displacement of each of the fin layered bodies 40A, 40B in the fin lateral direction. Thus, each of the fin layered bodies 40A, 40B is prevented from coming into contact with another component of the air conditioner adjacent in the fin lateral direction.

### (Fifth Embodiment)

The present fifth embodiment is different from the first embodiment described above with respect to a coupling member. Furthermore, the present fifth embodiment is similar to the third embodiment described above. Therefore, the present fifth embodiment will be described focusing on the different coupling member.

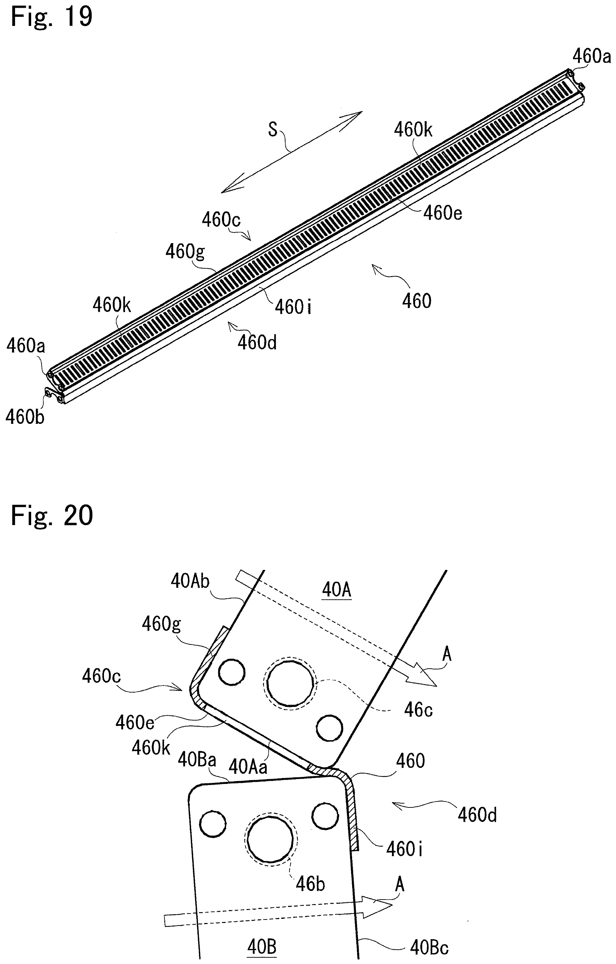

Fig. 18 is a front perspective view of a coupling member coupling two fin layered bodies in a heat exchanger according to the fifth embodiment. Furthermore, Fig. 19 is a rear perspective view of the coupling member according to the fifth embodiment. Fig. 20 is a cross-sectional view of the coupling member according to the fifth embodiment in a state where the two fin layered bodies are coupled as viewed in the fin layering direction.

As illustrated in Figs. 18 to 20, a coupling member 460 in the heat exchanger according to the present fifth embodiment is produced by, for example, pressing a single metal plate such as stainless steel. Furthermore, the coupling member 460 includes a first fixing portion 460a fixed to end plates provided at both ends of one fin layered body 40A and a second fixing portion 460b fixed to end plates provided at both ends of the other fin layered body 40B.

In the case of the present fifth embodiment, the coupling member 460 includes a first fin layered body support portion 460c that supports the one fin layered body 40A and a second fin layered body support portion 460d that supports the other fin layered body 40B.

Furthermore, in the case of the present fifth embodiment, the first fin layered body support portion 460c of the coupling member 460 includes a fin longitudinal direction contact portion 460e that is in contact with a fin longitudinal direction end surface 40Aa of the one fin layered body 40A and supports the fin layered body 40A in the fin longitudinal direction. The fin longitudinal direction contact portion 460e has a thin plate shape extending in the fin layering direction. Note that the second fin layered body support portion 460d does not substantially include a portion in contact with a fin longitudinal direction end surface 40Ba of the other fin layered body 40B.

Moreover, in the case of the present fifth embodiment, the first fin layered body support portion 460c of the coupling member 460 includes a fin lateral direction contact portion 460g that is in contact with one fin lateral direction end surface 40Ab of the fin layered body 40A in the fin lateral direction to support the fin layered body 40A. In the case of the present fifth embodiment, the fin lateral direction contact portion 460g has a thin plate shape extending in the fin layering direction, and is in contact with the fin lateral direction end surface 40Ab of the fin layered body 40A on a side where air A flows in. Furthermore, the fin lateral direction contact portion 460g is connected to one end (that is, an upstream end in the flow direction of the air A) of the fin longitudinal direction contact portion 460e in the fin lateral direction.

The second fin layered body support portion 460d of the coupling member 460 includes a fin lateral direction contact portion 460i that is in contact with the other fin lateral direction end surface 40Bc of the fin layered body 40B in the fin lateral direction to support the fin layered body 40B. In the case of the present fifth embodiment, the fin lateral direction contact portion 460i has a thin plate shape extending in the fin layering direction, and is in contact with the fin lateral direction end surface 40Bc of the fin layered body 40B on a side where the air A flows out. Furthermore, the fin lateral direction contact portion 460i is connected to the other end (that is, a downstream end in the flow direction of the air A) in the fin lateral direction of the fin longitudinal direction contact portion 460e in the first fin layered body support portion 460c.

Moreover, in the case of the present fifth embodiment, the fin longitudinal direction contact portion 460e in the first fin layered body support portion 460c of the coupling member 460 includes a plurality of through holes 460k. The plurality of through holes 460k are formed in the fin longitudinal direction contact portion 460e in a state of being arranged at intervals in the fin layering direction. The reason why the plurality of through holes 460k are provided will be described.

During the cooling operation, moisture contained in the air A condenses on the surfaces of a plurality of fins 46 in each of the fin layered bodies 40A, 40B. As illustrated in Fig. 2, water droplets generated by dew condensation in the fin layered bodies 40A, 40B finally move to the drain pan 22 located below the fin layered bodies 40A, 40B.

In a case where the one fin layered body 40A is located above the other fin layered body 40B, water droplets generated in the fin layered body 40A once move to the fin layered body 40B (that is, along the surface of the fin 46 in the fin layered body 40B,), and then move to the drain pan 22. At this time, the fin longitudinal direction contact portion 460e in the first fin layered body support portion 460c of the coupling member 460 obstructs the movement of the water droplets from the fin layered body 40A to the fin layered body 40B. In order to enable movement of the water droplets from the upper fin layered body 40A to the lower fin layered body 40B, the plurality of through holes 460k through which the water droplets pass are formed in the fin longitudinal direction contact portion 360e.

According to the present fifth embodiment, similarly to the first embodiment described above, in the plate-layered heat exchanger including the fin layered bodies 40A, 40B disposed adjacent to each other such that the fin layering directions are parallel to each other, it is possible to suppress contact between the fin layered body 40A and the fin layered body 40B.

Furthermore, the coupling member 460 suppresses displacement of each of the fin layered bodies 40A, 40B in the fin lateral direction. Thus, each of the fin layered bodies 40A, 40B is prevented from coming into contact with another component of the air conditioner adjacent in the fin lateral direction.

Moreover, in a case where the one fin layered body 40A is located above the other fin layered body 40B, water droplets generated by dew condensation in the fin layered body 40A can move to the fin layered body 40B without being blocked by the coupling member 460. As a result, the water droplets can move to the drain pan 22 located below the fin layered body 40B.

### (Sixth Embodiment)

The present sixth embodiment is different from the first embodiment described above with respect to a coupling member. Furthermore, the present sixth embodiment is similar to the fifth embodiment described above. Therefore, the present sixth embodiment will be described focusing on the different coupling member.

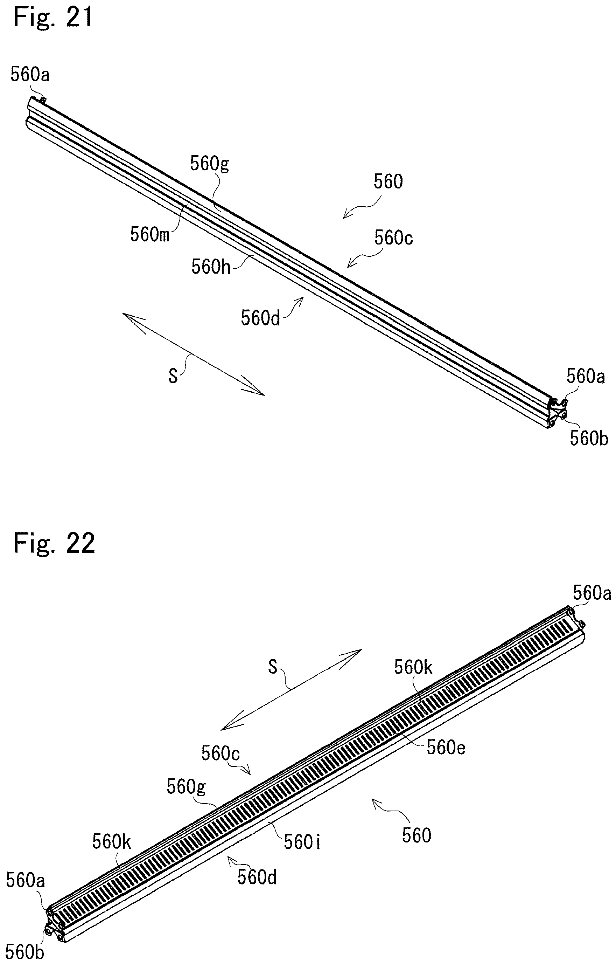

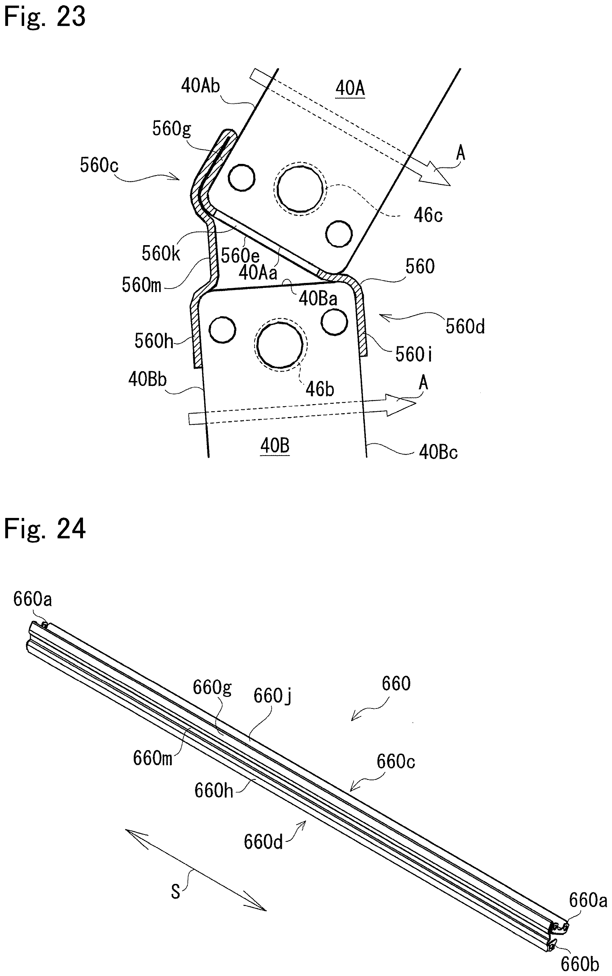

Fig. 21 is a front perspective view of a coupling member coupling two fin layered bodies in a heat exchanger according to the sixth embodiment. Furthermore, Fig. 22 is a rear perspective view of the coupling member according to the sixth embodiment. Fig. 23 is a cross-sectional view of the coupling member according to the sixth embodiment in a state where the two fin layered bodies are coupled as viewed in the fin layering direction.

As illustrated in Figs. 21 to 23, a coupling member 560 in the heat exchanger according to the present sixth embodiment is produced by, for example, pressing a single metal plate such as stainless steel. Furthermore, the coupling member 560 includes a first fixing portion 560a fixed to end plates provided at both ends of one fin layered body 40A and a second fixing portion 560b fixed to end plates provided at both ends of the other fin layered body 40B.

In the case of the present sixth embodiment, the coupling member 560 includes a first fin layered body support portion 560c that supports the one fin layered body 40A and a second fin layered body support portion 560d that supports the other fin layered body 40B.

Furthermore, in the case of the present sixth embodiment, the first fin layered body support portion 560c of the coupling member 560 includes a fin longitudinal direction contact portion 560e that is in contact with a fin longitudinal direction end surface 40Aa of the one fin layered body 40A and supports the fin layered body 40A in the fin longitudinal direction. The fin longitudinal direction contact portion 560e has a thin plate shape extending in the fin layering direction. Note that the second fin layered body support portion 560d does not substantially include a portion in contact with the fin longitudinal direction end surface 40Ba of the other fin layered body 40B.

The fin longitudinal direction contact portion 560e in the first fin layered body support portion 560c of the coupling member 560 includes a plurality of through holes 560k. The plurality of through holes 560k are formed in the fin longitudinal direction contact portion 560e in a state of being arranged at intervals in the fin layering direction.

Moreover, in the case of the present sixth embodiment, the first fin layered body support portion 560c of the coupling member 560 includes a fin lateral direction contact portion 560g that is in contact with one fin lateral direction end surface 40Ab of the fin layered body 40A in the fin lateral direction to support the fin layered body 40A. In the case of the present sixth embodiment, the fin lateral direction contact portion 560g has a thin plate shape extending in the fin layering direction, and is in contact with the fin lateral direction end surface 40Ab of the fin layered body 40A on a side where air A flows in. Furthermore, the fin lateral direction contact portion 560g is connected to one end (that is, an upstream end in the flow direction of the air A) of the fin longitudinal direction contact portion 560e in the fin lateral direction.

The second fin layered body support portion 560d of the coupling member 560 includes a fin lateral direction contact portion 560i that is in contact with the other fin lateral direction end surface 40Bc of the fin layered body 40B in the fin lateral direction to support the fin layered body 40B. In the case of the present sixth embodiment, the fin lateral direction contact portion 560i has a thin plate shape extending in the fin layering direction, and is in contact with the fin lateral direction end surface 40Bc of the fin layered body 40B on a side where the air A flows out. Furthermore, the fin lateral direction contact portion 560i is connected to the other end (that is, a downstream end in the flow direction of the air A) in the fin lateral direction of the fin longitudinal direction contact portion 560e in the first fin layered body support portion 560c.

Furthermore, the second fin layered body support portion 560d of the coupling member 560 includes a fin lateral direction contact portion 560h that is in contact with one fin lateral direction end surface 40Bb of the fin layered body 40B in the fin lateral direction to support the fin layered body 40B. In the case of the present sixth embodiment, the fin lateral direction contact portion 560h has a thin plate shape extending in the fin layering direction, and is in contact with the fin lateral direction end surface 40Bb of the fin layered body 40B on a side where the air A flows in.

In the case of the present sixth embodiment, the fin lateral direction contact portion 560h in the second fin layered body support portion 560d is connected to the fin lateral direction contact portion 560g in the first fin layered body support portion 560c via a connection portion 560m. The connection portion 560m extends between the fin lateral direction contact portions 560g, 560h to connect them.

Furthermore, the connection portion 560m suppresses the air A from flowing into the fin layered body 40A through the plurality of through holes 560k formed in the fin longitudinal direction contact portion 560e in the first fin layered body support portion 560c. The air A flowing into the fin layered body 40A through the through holes 560k does not flow along a longitudinal center portion (that is, a portion provided with an internal flow path 46a through which the refrigerant flows) of a plurality of fins 46 in the fin layered body 40A, and does not substantially exchange heat with the refrigerant. As a result, the heat exchange efficiency of the heat exchanger decreases. In order to suppress a shortcut of the air A through the through holes 560k that causes such a decrease in heat exchange efficiency, the connection portion 560m suppresses the passage of the air A through the through holes 560k.

According to the present sixth embodiment, as in the first embodiment described above, in the plate-layered heat exchanger including the fin layered bodies 40A, 40B disposed adjacent to each other such that the fin layering directions are parallel to each other, it is possible to suppress contact between the fin layered body 40A and the fin layered body 40B.

Furthermore, the coupling member 560 suppresses displacement of each of the fin layered bodies 40A, 40B in the fin lateral direction. Thus, each of the fin layered bodies 40A, 40B is prevented from coming into contact with another component of the air conditioner adjacent in the fin lateral direction.

Moreover, in a case where the one fin layered body 40A is located above the other fin layered body 40B, water droplets generated by dew condensation in the fin layered body 40A can move to the fin layered body 40B without being blocked by the coupling member 560. As a result, the water droplets can move to the drain pan 22 located below the fin layered body 40B.

Moreover, the connection portion 560m of the coupling member 560 suppresses the shortcut of the air A via the through holes 560k.

### (Seventh Embodiment)

The present seventh embodiment is an effective embodiment in a case where a fin layered body is likely to be displaced in the fin lateral direction because a size of the fin layered body in the fin layering direction is large, that is, the number of fin layered bodies is large.

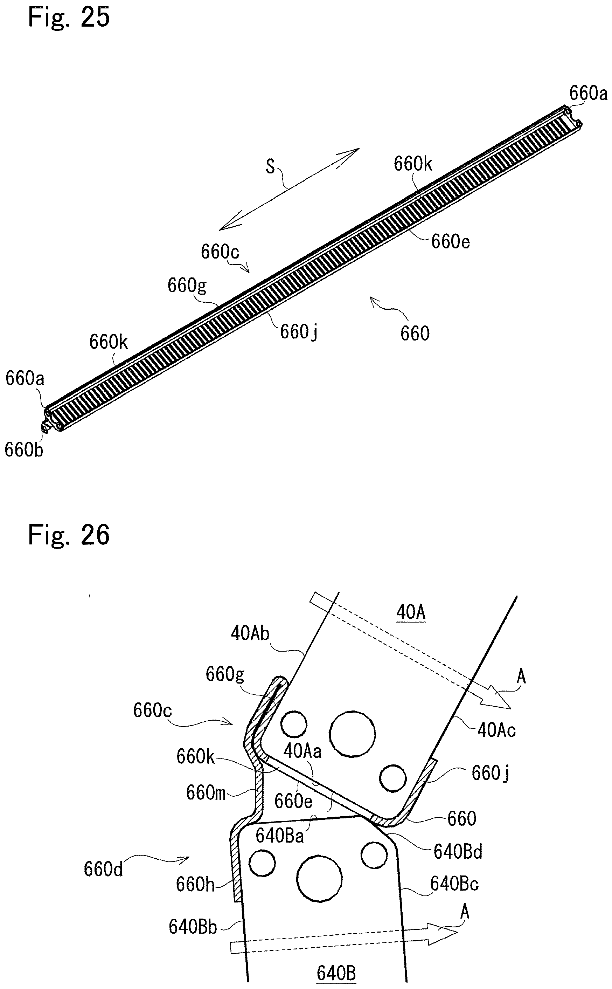

Fig. 24 is a front perspective view of a coupling member coupling two fin layered bodies in a heat exchanger according to the seventh embodiment. Furthermore, Fig. 25 is a rear perspective view of the coupling member according to the seventh embodiment, Fig. 26 is a cross-sectional view of the coupling member according to the seventh embodiment in a state where the two fin layered bodies are coupled as viewed in the fin layering direction.

As illustrated in Figs. 24 to 26, a coupling member 660 in the heat exchanger according to the present seventh embodiment is produced by, for example, pressing a single metal plate such as stainless steel. Furthermore, the coupling member 660 includes a first fixing portion 660a fixed to end plates provided at both ends of one fin layered body 40A and a second fixing portion 660b fixed to end plates provided at both ends of the other fin layered body 640B.

In the case of the present seventh embodiment, the coupling member 660 includes a first fin layered body support portion 660c that supports the one fin layered body 40A and a second fin layered body support portion 660d that supports the other fin layered body 640B.

Furthermore, in the case of the present seventh embodiment, the first fin layered body support portion 660c of the coupling member 660 includes a fin longitudinal direction contact portion 660e that is in contact with a fin longitudinal direction end surface 40Aa of the one fin layered body 40A and supports the fin layered body 40A in the fin longitudinal direction. The fin longitudinal direction contact portion 660e has a thin plate shape extending in the fin layering direction. Note that the second fin layered body support portion 660d does not substantially include a portion in contact with a fin longitudinal direction end surface 640Ba of the other fin layered body 640B.

The fin longitudinal direction contact portion 660e in the first fin layered body support portion 660c of the coupling member 660 includes a plurality of through holes 660k. The plurality of through holes 660k are formed in the fin longitudinal direction contact portion 660e in a state of being arranged at intervals in the fin layering direction.

Moreover, in the case of the present seventh embodiment, the first fin layered body support portion 660c of the coupling member 660 includes a fin lateral direction contact portion 660g that is in contact with one fin lateral direction end surface 40Ab of the fin layered body 40A in the fin lateral direction to support the fin layered body 40A. In the case of the present seventh embodiment, the fin lateral direction contact portion 660g has a thin plate shape extending in the fin layering direction, and is in contact with the fin lateral direction end surface 40Ab of the fin layered body 40A on a side where air A flows in. Furthermore, the fin lateral direction contact portion 660g is connected to one end (that is, an upstream end in the flow direction of the air A) of the fin longitudinal direction contact portion 660e in the fin lateral direction.

Moreover, in the case of the present seventh embodiment, the first fin layered body support portion 660c of the coupling member 660 includes a fin lateral direction contact portion 660j that is in contact with the other fin lateral direction end surface 40Ac of the fin layered body 40A in the fin lateral direction to support the fin layered body 40A. In the case of the present seventh embodiment, the fin lateral direction contact portion 660j has a thin plate shape extending in the fin layering direction, and is in contact with the fin lateral direction end surface 40Ac of the fin layered body 40A on a side where the air A flows out. Furthermore, the fin lateral direction contact portion 660j is connected to the other end (that is, a downstream end in the flow direction of the air A) in the fin lateral direction of the fin longitudinal direction contact portion 660e.

The second fin layered body support portion 660d of the coupling member 660 includes a fin lateral direction contact portion 660h that is in contact with one fin lateral direction end surface 640Bb of the fin layered body 640B in the fin lateral direction to support the fin layered body 640B. In the case of the present seventh embodiment, the fin lateral direction contact portion 660h has a thin plate shape extending in the fin layering direction, and is in contact with the fin lateral direction end surface 640Bb of the fin layered body 640B on a side where the air A flows in.

In the case of the present seventh embodiment, the fin lateral direction contact portion 660h in the second fin layered body support portion 660d is connected to the fin lateral direction contact portion 660g in the first fin layered body support portion 660c via a connection portion 660m. The connection portion 660m extends between the fin lateral direction contact portions 660g, 660h to connect them.

In the case of the present seventh embodiment, the fin layered body 40A is sandwiched between the fin lateral direction contact portions 660g, 660j in the first fin layered body support portion 660c. As a result, displacement of the fin layered body 40A in both directions in the fin lateral direction is limited.

On the other hand, in the fin layered body 640B, displacement in the fin lateral direction toward the upstream side in the flow direction of the air A is limited by the fin lateral direction contact portion 660h in the second fin layered body support portion 660d of the coupling member 660. On the other hand, the displacement in the fin lateral direction toward the downstream side in the flow direction of the air A is limited by the fin longitudinal direction contact portion 660e in the first fin layered body support portion 660c.

Specifically, in the case of the present seventh embodiment, the fin layered body 640B supported by the second fin layered body support portion 660d of the coupling member 660 includes a chamfer surface 640Bd between the fin longitudinal direction end surface 640Ba and the other fin lateral direction end surface 640Bc. That is, one corner portion of each of the plurality of fins in the fin layered body 640B is chamfered.

The fin layered body 640B is sandwiched between the fin lateral direction contact portion 660h of the coupling member 660 in contact with the fin lateral direction end surface 640Bb and the fin longitudinal direction contact portion 660e in contact with the chamfer surface 640Bd. As a result, in the fin layered body 640B, displacement in both directions in the fin lateral direction is limited by the coupling member 660, similarly to the fin layered body 40A.

According to the present seventh embodiment, similarly to the first embodiment described above, in the plate-layered heat exchanger including the fin layered bodies 40A, 640B disposed adjacent to each other such that the fin layering directions are parallel to each other, it is possible to suppress contact between the fin layered body 40A and the fin layered body 640B.

Furthermore, the coupling member 660 suppresses displacement of each of the fin layered bodies 40A, 640B in both directions in the fin lateral direction. Thus, each of the fin layered bodies 40A, 640B is prevented from coming into contact with another component of the air conditioner adjacent in the fin lateral direction.

Moreover, in a case where the one fin layered body 40A is located above the other fin layered body 640B, water droplets generated by dew condensation in the fin layered body 40A can move to the fin layered body 640B without being blocked by the coupling member 660. As a result, the water droplets can move to a drain pan 22 located below the fin layered body 640B.

Moreover, the connection portion 660m of the coupling member 660 suppresses a shortcut of the air A via the through holes 660k.

### (Eighth Embodiment)

The present eighth embodiment is an effective embodiment in a case where a fin layered body is likely to be displaced in the fin lateral direction because a size of the fin layered body in the fin layering direction is large, that is, the number of fin layered bodies is large, similarly to the seventh embodiment described above.

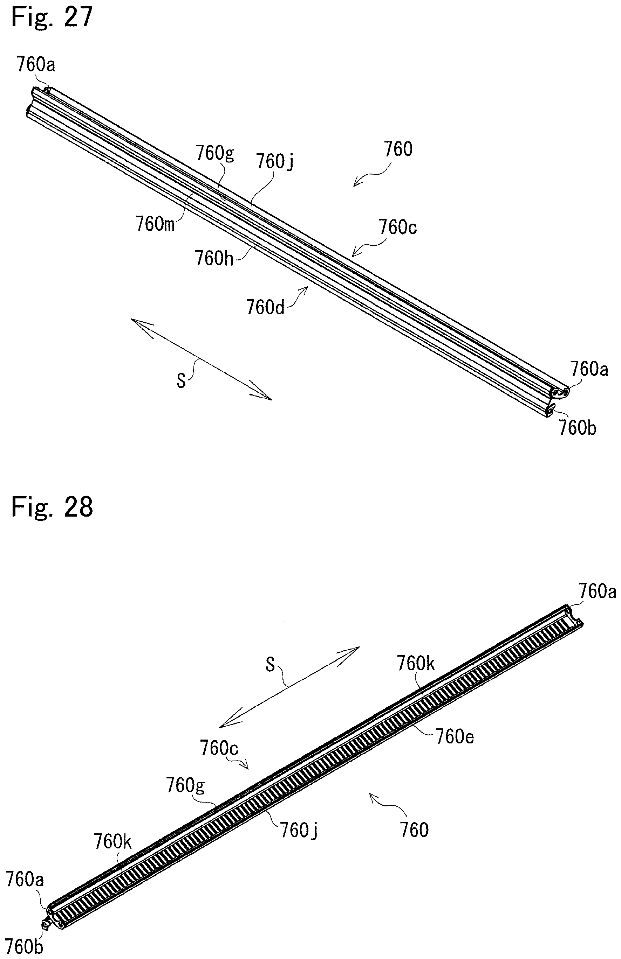

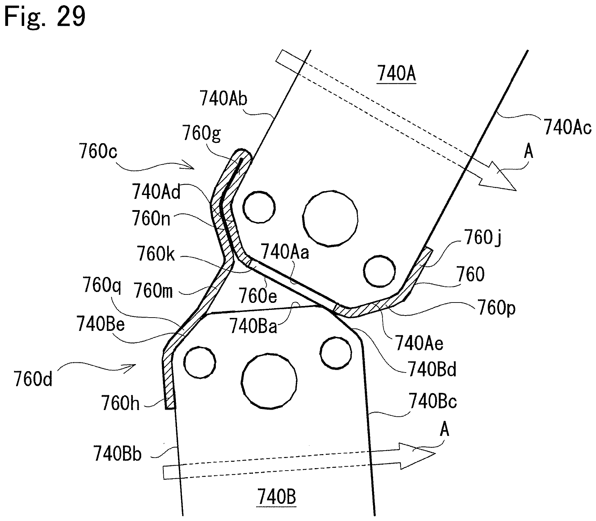

Fig. 27 is a front perspective view of a coupling member coupling two fin layered bodies in a heat exchanger according to the eighth embodiment. Furthermore, Fig. 28 is a rear perspective view of the coupling member according to the eighth embodiment. Fig. 29 is a cross-sectional view of the coupling member according to the eighth embodiment in a state where the two fin layered bodies are coupled as viewed in the fin layering direction.

As illustrated in Fig. 29, in the case of the present eighth embodiment, fin layered bodies 740A, 740B are different in shape from the fin layered bodies 40A, 40B of the above-described the first embodiment illustrated in Fig. 8 as viewed in the fin layering direction. Specifically, the fin layered body 740A includes chamfer surfaces 740Ad, 740Ae between each of fin lateral direction end surfaces 740Ab, 740Ac and a fin longitudinal direction end surface 740Aa. Similarly, the fin layered body 740B includes chamfer surfaces 740Bd, 740Be between each of fin lateral direction end surfaces 740Bb, 740Bc and a fin longitudinal direction end surface 740Ba.

As illustrated in Figs. 27 to 29, a coupling member 760 in the heat exchanger according to the present eighth embodiment is produced by, for example, pressing a single metal plate such as stainless steel. Furthermore, the coupling member 760 includes a first fixing portion 760a fixed to end plates provided at both ends of one fin layered body 740A and a second fixing portion 760b fixed to end plates provided at both ends of the other fin layered body 740B.

In the case of the present eighth embodiment, the coupling member 760 includes a first fin layered body support portion 760c that supports the one fin layered body 740A and a second fin layered body support portion 760d that supports the other fin layered body 740B.

Furthermore, in the case of the present eighth embodiment, the first fin layered body support portion 760c of the coupling member 760 includes a fin longitudinal direction contact portion 760e that is in contact with the fin longitudinal direction end surface 740Aa of the one fin layered body 740A and supports the fin layered body 740A in the fin longitudinal direction. The fin longitudinal direction contact portion 760e has a thin plate shape extending in the fin layering direction. Note that the second fin layered body support portion 760d does not substantially include a portion in contact with the fin longitudinal direction end surface 740Ba of the other fin layered body 740B.

The fin longitudinal direction contact portion 760e in the first fin layered body support portion 760c of the coupling member 760 includes a plurality of through holes 760k. The plurality of through holes 760k are formed in the fin longitudinal direction contact portion 760e in a state of being arranged at intervals in the fin layering direction.

Moreover, in the case of the present eighth embodiment, the first fin layered body support portion 760c of the coupling member 760 includes a fin lateral direction contact portion 760g that is in contact with one fin lateral direction end surface 740Ab of the fin layered body 740A in the fin lateral direction to support the fin layered body 740A. In the case of the present eighth embodiment, the fin lateral direction contact portion 760g has a thin plate shape extending in the fin layering direction, and is in contact with the fin lateral direction end surface 740Ab of the fin layered body 740A on a side where air A flows in.

In the case of the present eighth embodiment, in the first fin layered body support portion 760c of the coupling member 760, the fin lateral direction contact portion 760g is connected to the fin longitudinal direction contact portion 760e via a chamfer surface contact portion 760n. The chamfer surface contact portion 760n is in contact with the chamfer surface 740Ad of the fin layered body 740A to support the fin layered body 740A.

Moreover, in the case of the present eighth embodiment, the first fin layered body support portion 760c of the coupling member 760 includes a fin lateral direction contact portion 760j that is in contact with the other fin lateral direction end surface 740Ac of the fin layered body 740A in the fin lateral direction to support the fin layered body 740A. In the case of the present eighth embodiment, the fin lateral direction contact portion 760j has a thin plate shape extending in the fin layering direction, and is in contact with the fin lateral direction end surface 740Ac of the fin layered body 740A on a side where the air A flows out.

In the case of the present eighth embodiment, in the first fin layered body support portion 760c of the coupling member 760, the fin lateral direction contact portion 760j is connected to the fin longitudinal direction contact portion 760e via a chamfer surface contact portion 760p. The chamfer surface contact portion 760p is in contact with the chamfer surface 740Ae of the fin layered body 740A to support the fin layered body 740A.

The second fin layered body support portion 760d of the coupling member 760 includes a fin lateral direction contact portion 760h that is in contact with one fin lateral direction end surface 740Bb of the fin layered body 740B in the fin lateral direction to support the fin layered body 740B. In the case of the present eighth embodiment, the fin lateral direction contact portion 760h has a thin plate shape extending in the fin layering direction, and is in contact with the fin lateral direction end surface 740Bb of the fin layered body 740B on a side where the air A flows in.

In the case of the present eighth embodiment, the fin lateral direction contact portion 760h in the second fin layered body support portion 760d is connected to the fin lateral direction contact portion 760g in the first fin layered body support portion 760c via the connection portion 760m and a chamfer surface contact portion 760q. The chamfer surface contact portion 760q is in contact with the chamfer surface 740Be of the fin layered body 740B to support the fin layered body 740B. The connection portion 760m extends between the fin lateral direction contact portion 760g and the chamfer surface contact portion 760q to connect them.

In the case of the present eighth embodiment, the fin layered body 740A is sandwiched between the fin lateral direction contact portions 760g, 760j in the first fin layered body support portion 760c. As a result, displacement of the fin layered body 740A in both directions in the fin lateral direction is limited.

On the other hand, in the fin layered body 740B, displacement in the fin lateral direction toward the upstream side in the flow direction of the air A is limited by the fin lateral direction contact portion 760h in the second fin layered body support portion 760d of the coupling member 760. On the other hand, displacement in the fin lateral direction toward the downstream side in the flow direction of the air A is limited by contact of the chamfer surface 740Bd of the fin layered body 740B with the fin longitudinal direction contact portion 760e in the first fin layered body support portion 760c.

According to the present eighth embodiment, similarly to the first embodiment described above, in the plate-layered heat exchanger including the fin layered bodies 740A, 740B disposed adjacent to each other such that the fin layering directions are parallel to each other, contact between the fin layered body 740A and the fin layered body 740B can be suppressed.

Furthermore, the coupling member 760 suppresses displacement of each of the fin layered bodies 740A, 740B in both directions in the fin lateral direction. Thus, each of the fin layered bodies 740A, 740B is prevented from coming into contact with another component of the air conditioner adjacent in the fin lateral direction.

Moreover, in a case where the one fin layered body 740A is located above the other fin layered body 740B, water droplets generated by dew condensation in the fin layered body 740A can move to the fin layered body 740B without being blocked by the coupling member 760. As a result, the water droplets can move to a drain pan 22 located below the fin layered body 740B.

Moreover, the connection portion 760m of the coupling member 760 suppresses a shortcut of the air A via the through holes 760k.

Although the present disclosure has been described above with reference to the above-described plurality of embodiments, the present disclosure is not limited to the above-described embodiments.

For example, in the case of the above-described first embodiment, as illustrated in Fig. 8, the fin layered bodies 40A, 40B are coupled by the coupling member 60 such that the respective one fin longitudinal direction end surfaces 40Aa, 40Ba face each other and approach each other from one end toward the other end in the fin lateral direction. However, the embodiment of the present disclosure is not limited thereto. For example, the opposing fin longitudinal direction end surfaces 40Aa, 40Ba of the fin layered bodies 40A, 40B may be parallel to each other.

Furthermore, the heat exchanger according to the first embodiment described above is provided in an air conditioner that performs indoor air conditioning. However, the embodiment of the present disclosure is not limited thereto. The heat exchanger according to the embodiment of the present disclosure can be used in a device that needs to perform heat exchange between a first fluid and a second fluid.

That is, in a broad sense, a heat exchanger according to an embodiment of the present disclosure includes: first and second fin layered bodies respectively formed by layering a plurality of fins each including an internal flow path through which a first fluid flows with a gap through which a second fluid passes; and a coupling member that couples the first and second fin layered bodies such that fin layering directions of the first and second fin layered bodies are parallel to each other and respective one fin longitudinal direction end surfaces of the first and second fin layered bodies are adjacent to each other, in which the coupling member couples the first and second fin layered bodies with at least a part interposed between the fin longitudinal direction end surface of the first fin layered body and the fin longitudinal direction end surface of the second fin layered body.

The present disclosure is applicable not only to a heat exchanger that performs heat exchange between a refrigerant and air but also between a first fluid and a second fluid.

## Claims

1. A heat exchanger comprising:
first and second fin layered bodies respectively formed by layering a plurality of fins each including an internal flow path through which a first fluid flows with a gap through which a second fluid passes; and
a coupling member that couples the first and second fin layered bodies such that fin layering directions of the first and second fin layered bodies are parallel to each other and respective one fin longitudinal direction end surfaces of the first and second fin layered bodies are adjacent to each other,
wherein the coupling member couples the first and second fin layered bodies with at least a part of the coupling member interposed between the fin longitudinal direction end surface of the first fin layered body and the fin longitudinal direction end surface of the second fin layered body.

2. The heat exchanger according to claim 1, wherein the first and second fin layered bodies are coupled by the coupling member such that the fin longitudinal direction end surface in the first fin layered body and the fin longitudinal direction end surface in the second fin layered body approach each other from one end toward another end in a fin lateral direction while facing each other.

3. The heat exchanger according to claim 2, wherein
the coupling member includes:
a first fin layered body support portion that contacts and supports the first fin layered body; and
a second fin layered body support portion that contacts and supports the second fin layered body.

4. The heat exchanger according to claim 3, wherein the first fin layered body support portion includes a fin longitudinal direction contact portion in contact with the fin longitudinal direction end surface of the first fin layered body.

5. The heat exchanger according to claim 4, wherein the fin longitudinal direction contact portion of the first fin layered body support portion includes a plurality of through holes.

6. The heat exchanger according to claim 3, wherein the first fin layered body support portion includes a fin lateral direction contact portion in contact with one fin lateral direction end surface of the first fin layered body.

7. The heat exchanger according to claim 3, wherein the second fin layered body support portion includes a fin longitudinal direction contact portion in contact with the fin longitudinal direction end surface of the second fin layered body.

8. The heat exchanger according to claim 3, wherein the second fin layered body support portion includes a fin lateral direction contact portion in contact with one fin lateral direction end surface of the second fin layered body.

9. The heat exchanger according to claim 3, wherein
the first fin layered body support portion includes:
a fin longitudinal direction contact portion in contact with the fin longitudinal direction end surface of the first fin layered body; and
a fin lateral direction contact portion in contact with one fin lateral direction end surface of the first fin layered body,
the second fin layered body support portion includes a fin lateral direction contact portion in contact with one fin lateral direction end surface of the second fin layered body,
the fin longitudinal direction contact portion of the first fin layered body support portion includes a plurality of through holes, and
the coupling member further includes a connection portion that extends and connects between the fin lateral direction contact portion in the first fin layered body support portion and the fin lateral direction contact portion in the second fin layered body support portion.

10. The heat exchanger of claim 3, wherein
the first fin layered body support portion includes:
a fin longitudinal direction contact portion in contact with the fin longitudinal direction end surface of the first fin layered body;
a first fin lateral direction contact portion in contact with one fin lateral direction end surface of the first fin layered body; and
a second fin lateral direction contact portion in contact with another fin lateral direction end surface of the first fin layered body,
the second fin layered body support portion includes a fin lateral direction contact portion in contact with one fin lateral direction end surface of the second fin layered body,
the fin longitudinal direction contact portion of the first fin layered body support portion includes a plurality of through holes,
the coupling member includes a connection portion that extends and connects between the first fin lateral direction contact portion in the first fin layered body support portion and the fin lateral direction contact portion in the second fin layered body support portion,
the second fin layered body includes a chamfer surface between the fin longitudinal direction end surface and the another fin lateral direction end surface, and
the fin longitudinal direction contact portion in the first fin layered body support portion contacts the chamfer surface of the second fin layered body.

11. The heat exchanger according to claim 3, wherein
the first fin layered body includes a first chamfer surface between the fin longitudinal direction end surface and one fin lateral direction end surface, and a second chamfer surface between the fin longitudinal direction end surface and another fin lateral direction end surface,
the second fin layered body includes a third chamfer surface between the fin longitudinal direction end surface and one fin lateral direction end surface, and a fourth chamfer surface between the fin longitudinal direction end surface and another fin lateral direction end surface,
the first fin layered body support portion includes:
a fin longitudinal direction contact portion in contact with the fin longitudinal direction end surface of the first fin layered body;
a first fin lateral direction contact portion in contact with one fin lateral direction end surface of the first fin layered body;
a second fin lateral direction contact portion in contact with another fin lateral direction end surface of the first fin layered body;
a first chamfer surface contact portion in contact with the first chamfer surface; and
a second chamfer surface contact portion in contact with the second chamfer surface,
the second fin layered body support portion includes:
a fin lateral direction contact portion in contact with the one fin lateral direction end surface of the second fin layered body; and
a third chamfer surface contact portion in contact with the third chamfer surface,
the coupling member includes a connection portion that extends and connects between the first fin lateral direction contact portion in the first fin layered body support portion and the third chamfer surface contact portion in the second fin layered body support portion, and
the fin longitudinal direction contact portion in the first fin layered body support portion contacts the fourth chamfer surface of the second fin layered body.

12. The heat exchanger according to claim 1, wherein
each of the first and second fin layered bodies includes end plates at both ends in each of the fin layering directions, and
both ends of the coupling member in the fin layering direction are fixed to the end plates of each of the first and second fin layered bodies.

13. The heat exchanger according to claim 1, wherein the coupling member is a pressed product of one metal plate.

14. An air conditioner comprising:
a compressor that delivers a refrigerant;
a heat exchanger through which a refrigerant flows; and
a fan that generates a flow of air passing through the heat exchanger,
wherein the heat exchanger includes:
first and second fin layered bodies respectively formed by layering a plurality of fins each including an internal flow path through which a refrigerant flows with a gap through which air passes; and
a coupling member that couples the first and second fin layered bodies such that fin layering directions of the first and second fin layered bodies are parallel to each other and respective one fin longitudinal direction end surfaces of the first and second fin layered bodies are adjacent to each other, and
the coupling member couples the first and second fin layered bodies with at least a part of the coupling member interposed between the fin longitudinal direction end surface of the first fin layered body and the fin longitudinal direction end surface of the second fin layered body.
